# DEMANDE DE BREVET EUROPEEN

(11) **EP 4 358 657 A1**
(43) Date de publication de la demande: **24.04.2024**
(21) Numéro de dépôt: 23204533.6
(22) Date de dépôt: 19.10.2023
(51) Int. Cl.: H05K 3/20, H05K 3/28

(54) **FILM DE RESINE**

(30) Priorité: 20.10.2022 FR 2210869
(71) Demandeur: Airbus Operations (S.A.S.), 31060 Toulouse Cedex 9 (FR); Airbus Operations S.L., 28906 Getafe Madrid (ES)
(72) Inventeur: MURILLO, Richard, 31060 TOULOUSE (FR); DE LA MOTA MENDIOLA, Matilde, 28906 GETAFE-MADRID (ES); LAGACHE, Nathan, 31060 TOULOUSE (FR)
(74) Mandataire: Cabinet Le Guen Maillet

(57) **Abrégé**

Un film de résine (6) adapté pour maintenir une piste métallique (2) conductrice contre un panneau (1). Le film de résine (6) recouvre partiellement la piste métallique (2) conductrice, de sorte que la piste métallique (2) conductrice présente au moins une zone (8) dépourvue du film de résine (6) pour permettre une connexion électrique par contact. Ainsi, dans le cadre d'un assemblage sur un panneau, la piste métallique intégrée entre le panneau et le film de résine est protégée ce qui rend cette solution technique particulièrement robuste. En outre, d'une manière particulièrement astucieuse, le film de résine permet d'isoler électriquement la piste métallique des éléments environnants, et les zones dépourvues de film de résine permettent une connexion électrique par contact.

## Description

### DOMAINE TECHNIQUE

L'invention concerne le domaine de l'intégration d'une piste métallique conductrice sur un panneau.

### ETAT DE LA TECHNIQUE ANTERIEURE

D'une manière connue, la circulation de courant électrique dans un véhicule est assurée par des fils ou câbles électriques, par la structure elle-même si cette dernière est suffisamment conductrice (e.g., structure métallique), ou bien par un assemblage d'éléments métalliques boulonnés aux panneaux de la structure si cette dernière n'est pas assez conductrice (e.g., si la structure est en matériaux composite à base de fibres de carbone ou de fibres de verre). Ces éléments permettent l'alimentation de différents organes du véhicule, la circulation de signaux, le drainage de courant de court-circuit, ou encore la protection parafoudre de l'aéronef.

Usuellement, l'installation de ces différents éléments conducteurs au sein de la structure d'un véhicule est réalisée lors de l'assemblage final du véhicule ou, lors de l'assemblage de sous-ensembles. En conséquence, la durée de cette installation influence la cadence de production associée à une chaîne d'assemblage de véhicules.

Ainsi, dans ce contexte, il est souhaitable d'intégrer les éléments conducteurs au sein même des éléments de la structure, lors de leur fabrication.

### EXPOSE DE L'INVENTION

A cet effet, selon un premier aspect, il est proposé un film de résine adapté pour maintenir une piste métallique conductrice contre un panneau. Le film de résine recouvre partiellement la piste métallique conductrice, de sorte que la piste métallique conductrice présente au moins une zone dépourvue du film de résine pour permettre une connexion électrique par contact.

Ainsi, dans le cadre d'un assemblage sur un panneau, la piste métallique intégrée entre le panneau et le film de résine est protégée ce qui rend cette solution technique particulièrement robuste. En outre, d'une manière particulièrement astucieuse, le film de résine permet d'isoler électriquement la piste métallique des éléments environnants, et les zones dépourvues de film de résine permettent une connexion électrique par contact.

Selon un autre aspect, il est proposé un aéronef comprenant au moins un panneau de structure d'un aéronef comprenant une piste métallique conductrice positionnée contre une face du panneau de structure. L'aéronef comprend un film de résine recouvrant partiellement la piste métallique conductrice et la face du panneau de structure pour maintenir la piste métallique conductrice contre le panneau de structure, la piste métallique conductrice présentant au moins une zone dépourvue du film de résine pour permettre une connexion électrique par contact.

Selon une disposition particulière, le panneau de structure est en matériau composite.

Selon un autre aspect, il est proposé un procédé d'assemblage d'un panneau de structure d'un aéronef. Le procédé comprend au moins les étapes suivantes :
- découper une piste métallique conductrice dans une plaque en matériau métallique conducteur ;
- appliquer un film de résine contre la piste métallique conductrice pour recouvrir partiellement la piste métallique conductrice, afin de laisser au moins une zone dépourvue de film de résine ; et
- positionner la piste métallique conductrice et le film de résine contre une face du panneau de structure, de sorte que le film de résine recouvre au moins partiellement la face du panneau de structure pour maintenir la piste métallique contre le panneau de structure.

Ainsi, le procédé proposé permet d'assembler simplement un panneau de structure comprenant une piste métallique conductrice. L'application du film de résine permet d'assembler la piste métallique au panneau de structure tout en garantissant l'isolation électrique de la piste métallique par rapport à des éléments environnants. En outre, les zones laissées dépourvues de film de résine permettent de pouvoir simplement effectuer une connexion électrique par contact sur ces zones.

Selon une disposition particulière, le procédé comprend l'étape suivante :
- masquer au moins une zone de la piste métallique conductrice avec une bande de masquage recouvrant chaque zone prédéterminée, et dans lequel le film de résine est appliqué sur la piste métallique conductrice et sur chaque bande de masquage.

Selon une disposition particulière, le procédé comprend l'étape suivante :
- retirer chaque bande de masquage recouverte du film de résine, après le positionnement du film de résine et de la piste métallique.

Selon une disposition particulière, le film de résine est appliqué avec une nappe de transfert.

Selon une disposition particulière le film de résine et la piste métallique sont positionnés de la façon suivante :
- positionner la nappe de transfert avec la piste métallique conductrice sur la face du panneau de structure ;
- chauffer le panneau de structure, la piste métallique conductrice et la nappe de transfert pour thermocoller le film de résine sur la piste métallique conductrice et la face du panneau de structure ;
- retirer la nappe de transfert pour conserver le film de résine thermocollé sur la piste métallique conductrice et la face du panneau de structure.

Selon une disposition particulière, le panneau de structure est en matériau composite et le chauffage du panneau de structure permet de cuire le matériau composite du panneau de structure.

Selon un autre aspect, il est proposé un procédé d'assemblage d'un aéronef comportant une phase d'assemblage de plusieurs panneaux de structure, comprenant l'étape suivante :
- connecter électriquement par contact chaque zone des panneaux de structure, pour former un réseau de circulation d'électricité.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1] illustre schématiquement une étape d'un procédé d'assemblage d'un panneau de structure d'un aéronef comprenant une piste métallique conductrice positionnée contre une face du panneau de structure ;
[Fig. 2] illustre schématiquement une autre étape du procédé d'assemblage du panneau de structure ;
[Fig. 3] illustre schématiquement encore une autre étape du procédé d'assemblage du panneau de structure ;
[Fig. 4] illustre schématiquement encore une autre étape d'un procédé d'assemblage du panneau de structure ;
[Fig. 5] illustre schématiquement un aéronef comportant au moins un panneau de structure comprenant une piste métallique conductrice positionnée contre une face dudit panneau de structure d'assemblage ; et
[Fig. 6] illustre schématiquement l'exécution du procédé d'assemblage du panneau de structure.

### EXPOSE DETAILLE DE MODES DE REALISATION

### Film de résine

Il est proposé un film de résine 6 recouvrant partiellement une piste métallique 2 conductrice qui sera décrite ci-après. Le film de résine 6 recouvre partiellement la piste métallique 2 conductrice, de sorte que la piste métallique 2 conductrice présente au moins une zone 8 dépourvue du film de résine 6 pour permettre une connexion électrique par contact. Tel que cela sera décrit ci-après, le film de résine 6 est adapté pour maintenir la piste métallique 2 conductrice contre un panneau 1.

Il est précisé que par recouvrant partiellement, il est entendu que le film de résine 6 recouvre la piste métallique 2 à l'exception de certaines zones 8 qui sont laissées dépourvues de film de résine 6. En d'autres termes, certaines zones 8 prédéterminées de la piste métallique 2 ne sont pas recouvertes par le film de résine 6. Tel que cela sera décrit ci-après, les zones 8 qui sont laissées dépourvues de film de résine 6 permettent une connexion électrique par contact avec un autre élément conducteur. En d'autres termes, le film de résine 6 est électriquement isolant. Ainsi, une portion de la piste métallique 2 qui est positionnée contre une face du panneau 1 de structure et qui est recouverte du film de résine 6 est électriquement isolée. Les zones 8 qui sont laissées dépourvues de film de résine 6 ne sont pas électriquement isolées et permettent une connexion électrique par contact sur ladite zone 8 laissée dépourvue du film de résine 6. En sus, selon un mode de réalisation particulier, le film de résine 6 est adapté pour protéger la piste métallique 2 de la corrosion et d'éventuels chocs.

Selon une disposition particulière, le film de résine 6 est un film de résine époxy présentant une épaisseur comprise entre 15µm et 30µm.

Selon une autre disposition particulière, le film de résine 6 est un film de résine époxy présentant une épaisseur comprise entre 30µm et 150µm.

### Panneau de structure

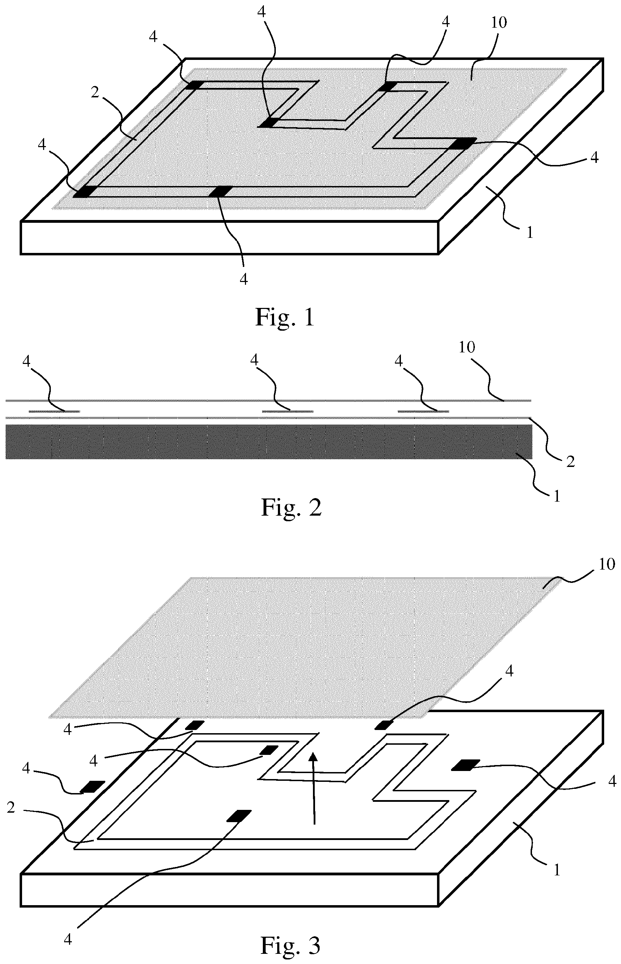

En référence à la Fig. 1, il est proposé un panneau 1 de structure d'un aéronef comprenant une piste métallique 2 conductrice. Selon une disposition particulière, le panneau 1 de structure peut être en matériau composite. Typiquement, le matériau composite comprend des fibres et une résine. Les fibres peuvent, par exemple, être des fibres de verre, de carbone ou d'aramide. Selon un mode de réalisation, les fibres sont préimprégnées de résine polymère. Selon un autre mode de réalisation, les fibres sont sous forme de nappes qui doivent être imprégnées de résines polymère pour constituer le panneau 1 de structure. Le panneau 1 de structure peut typiquement couvrir une surface de plusieurs mètres carrés. En d'autres termes, selon un exemple de réalisation, le panneau 1 de structure peut présenter des cotes de longueur et de largeur de plusieurs mètres chacune.

Selon une disposition particulière, la piste métallique 2 conductrice est positionnée contre une face du panneau 1 de structure. La piste métallique 2 conductrice peut, par exemple, être une piste rigide de cuivre. La piste métallique 2 est dimensionnée pour permettre la conduction et la circulation d'un courant électrique. Selon un mode de réalisation, la piste métallique 2 peut présenter une épaisseur de l'ordre de 8µm à 200µm. Selon un autre mode de réalisation, la piste métallique 2 peut présenter une épaisseur de plusieurs millimètres. Il est précisé que l'épaisseur de la piste métallique 2 est adaptée au type de courant électrique devant y circuler.

En outre, le panneau 1 de structure comprend un film de résine 6, tel que décrit ci-avant, qui recouvre partiellement la piste métallique 2 conductrice et la face du panneau 1 de structure pour maintenir la piste métallique 2 conductrice contre le panneau 1 de structure.

### Aéronef

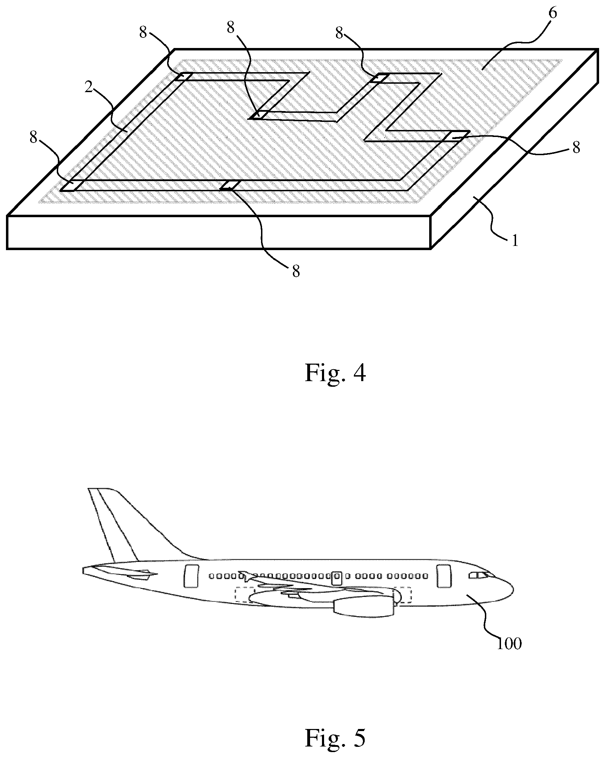

Selon un autre aspect, comme illustré sur la Fig. 5, il est proposé un aéronef 100 comprenant au moins un exemplaire du panneau 1 de structure. Typiquement, l'aéronef 100 comprend plusieurs panneaux 1 de structure assemblés formant le fuselage ou une portion du fuselage de l'aéronef 100.

Dans un mode de réalisation particulier, les pistes métalliques 2 conductrices de chaque panneau 1 de structure sont connectées pour former un réseau de pistes métalliques 2 conductrices. Le réseau de pistes métalliques 2 conductrice peut avoir de multiples fonctions comme permettre la circulation d'électricité entre différents organes de l'aéronef 100, permettre l'alimentation électrique d'équipements de transmission de signaux électriques, permettre le drainage de courants de court-circuit ou encore, permettre de garantir une protection contre les courants de foudre en formant une structure de type cage de Faraday.

### Procédé d'assemblage

Selon un autre aspect, il est proposé un procédé d'assemblage du panneau 1 de structure.

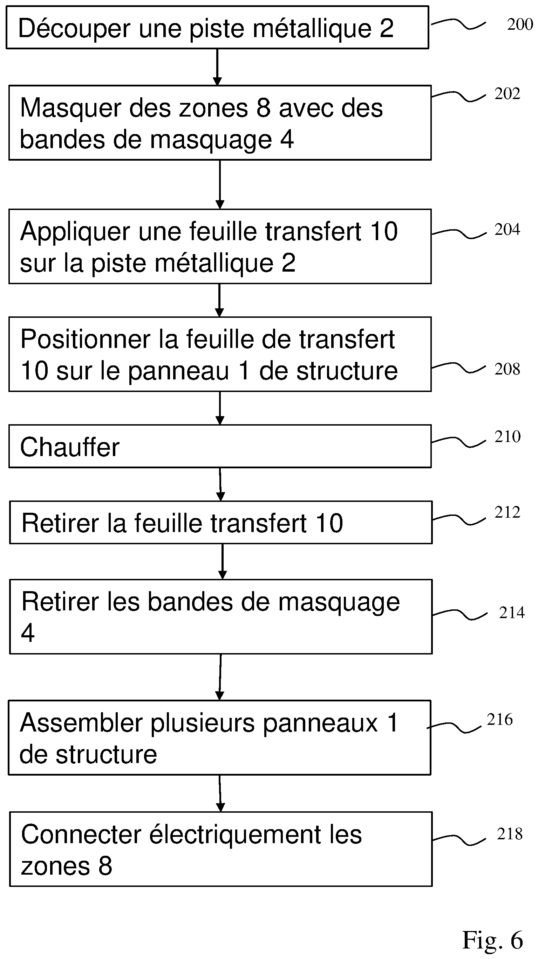

Des résultats intermédiaires des étapes du procédé sont schématisés sur les Figs. 1 à 4, et la Fig. 6 est un schéma bloc du déroulement du procédé, selon une disposition particulière.

Le procédé comprend principalement les étapes suivantes :
- fournir un panneau 1 de structure pour l'aéronef 100 ;
- découper (étape 200) une piste métallique 2 conductrice dans une plaque en matériau métallique conducteur ;
- appliquer (étape 204) un film 6 de résine contre la piste métallique 2 conductrice pour recouvrir partiellement la piste métallique 2 conductrice, afin de laisser au moins une zone 8 dépourvue de film 6 de résine ; et
- positionner (étape 208) la piste métallique 2 conductrice et le film de résine 6 contre une face du panneau 1 de structure, de sorte que le film de résine 6 recouvre au moins partiellement la face du panneau 1 de structure pour maintenir la piste métallique 2 contre le panneau 1 de structure.

Selon un mode de réalisation particulier, le panneau 1 de structure fourni peut être en matériau préimprégné (tel que de la fibre de carbone). Selon un autre mode de réalisation, le panneau 1 de structure peut être en matériau composite présentant des nappes fibreuses (telles que des nappes en fibres de carbone) qui doivent être imprégnées d'une résine et polymérisées pour former le panneau 1 de structure. Selon ces deux modes de réalisation, le panneau 1 de structure fourni peut être en cours de drapage ou être déjà polymérisé.

Selon une disposition particulière, le procédé comprend une étape de masquage (étape 202) d'au moins une zone 8 prédéterminée de la piste métallique 2 conductrice avec une bande de masquage 4 recouvrant la, ou chaque, zone 8. Selon une disposition particulière, la bande de masquage 4 est une bande en polyester adaptée pour résister à une température de polymérisation du film de résine 6.

Cette étape de masquage (étape 202) est réalisée avant l'étape d'application (étape 204) du film de résine 6 sur la piste métallique 2. Tel que cela sera détaillé ci-après, l'application d'une bande de masquage 4 (étape de masquage 202) sur des zones 8 prédéterminées de la piste métallique 2 permet ensuite d'obtenir des zones 8 dépourvues du film de résine 6, c'est-à-dire dépourvues d'isolant. Selon cette disposition particulière, après le masquage (étape 202), le film de résine 6 est appliqué sur la piste métallique 2 conductrice présentant des zones 8 masquées avec de la bande de masquage 4. Puis, le film de résine 6 et la piste métallique 2 conductrice présentant des zones 8 masquées avec de la bande de masquage 4 sont positionnés sur le panneau 1 de structure. Il est précisé que le film de résine 6 permet de faciliter la manipulation de la piste métallique 2. Ainsi, dans le cas d'une piste métallique 2 de quelques micromètres d'épaisseur et/ou présentant une découpe complexe, tout en étant longue de plusieurs mètres, le film de résine 6 permet de manipuler aisément la piste métallique 2 pour la positionner sur le panneau 1 de structure.

Il est précisé que, selon une disposition particulière, le film de résine 6 peut être appliqué (étape 204) à l'aide d'une nappe de transfert 10 (« wet peel ply » en anglais). Par nappe de transfert 10, il est entendu une nappe en tissu ou en cellulose enduite du film de résine 6 non cuit. L'utilisation d'une nappe de transfert 10 est une disposition technique particulièrement avantageuse qui permet de faciliter le transport et la manipulation du film de résine 6 et de la piste métallique 2 collée au film de résine 6.

Il est précisé que selon un autre mode de réalisation, le film de résine 6 est appliqué sans nappe de transfert 10. D'une manière préférentielle, lorsque le film de résine 6 est appliqué sans nappe de transfert 10, le film de résine présente une épaisseur comprise entre 30µm et 150µm.

Les Figs. 1 et 2 représentent l'empilement des couches de panneau 1 de structure, piste métallique 2, bandes de masquage 4 et nappe de transfert 10 comprenant le film de résine 6, obtenues après le dépôt de la nappe de transfert 10 comprenant le film de résine 6. En d'autres termes, la piste métallique 2 est positionnée sur le panneau de structure 1. Les bandes de masquage 4 sont positionnées sur les zones 8 de la piste métallique 2. Enfin, la nappe de transfert 10 comprenant le film de résine 6 recouvre les bandes de masquage 4, la piste métallique 2 et le panneau de structure.

Selon une disposition particulière, le procédé comprend ensuite une étape de chauffage (étape 210) du panneau 1 de structure, de la piste métallique 2 conductrice et de la nappe de transfert 10 pour thermocoller le film de résine 6 sur la piste métallique 2 conductrice et la face du panneau 1 de structure. Typiquement, le chauffage peut être réalisé dans un four. L'objectif de l'étape de chauffage (étape 210) est de thermocoller le film de résine 6 pour qu'il adhère au panneau 1 de structure et à la piste métallique 2, en les recouvrant de manière uniforme, ce qui permet de maintenir la piste métallique 2 conductrice contre le panneau 1 de structure. Selon une disposition particulière, le chauffage permet de cuire le panneau 1 de structure en matériau composite.

Après l'étape de chauffage (étape 210), telle que schématisée sur la Fig. 4, la nappe de transfert 10 est retirée 212, laissant le film de résine 6 thermocollé (cuit) sur le panneau 1 de structure, la piste métallique 2 et les bandes de masquage 4.

Dans le cas où le panneau 1 de structure est en cours de drapage, l'étape de chauffage 210 permet de polymériser le film de résine 6 et le panneau 1 de structure.

Ensuite, tel que schématisé sur la Fig. 4, les bandes de masquage 4 sont retirées (étape 214). Les zones 8 de la piste métallique 2 conductrices qui étaient sous les bandes de masquage 4 sont dépourvues du film de résine 6, ce qui permet d'établir une connexion électrique par contact sur ces zones 8.

Selon une disposition particulière, il est possible d'assembler (étape 216) plusieurs panneaux 1 de structure, puis de connecter (étape 218) électriquement par contact les zones 8 de ces panneaux 1 de structure pour former un circuit électrique. Ces deux dernières étapes d'assemblage (étapes 216 et 218) s'intègrent dans le cadre d'un procédé d'assemblage de l'aéronef 100.

## Revendications

1. Panneau (1) de structure d'un aéronef (100) comprenant une piste métallique (2) conductrice positionnée contre une face du panneau (1) de structure, et comprenant un film de résine (6) adapté pour maintenir la piste métallique (2) conductrice contre le panneau (1), le panneau (1) de structure étant **caractérisé en ce que** le film de résine (6) recouvre partiellement la piste métallique (2) conductrice, de sorte que la piste métallique (2) conductrice présente au moins une zone (8) dépourvue du film de résine (6) pour permettre une connexion électrique par contact.

2. Aéronef (100) comprenant au moins un panneau (1) de structure d'un aéronef (100) comprenant une piste métallique (2) conductrice positionnée contre une face du panneau (1) de structure, l'aéronef (100) étant **caractérisé en ce qu'**il comprend un film de résine (6) recouvrant partiellement la piste métallique (2) conductrice et la face du panneau (1) de structure pour maintenir la piste métallique (2) conductrice contre le panneau (1) de structure, la piste métallique (2) conductrice présentant au moins une zone (8) dépourvue du film de résine (6) pour permettre une connexion électrique par contact.

3. Aéronef (100) selon la revendication 2, dans lequel le panneau (1) de structure est en matériau composite.

4. Procédé d'assemblage d'un panneau (1) de structure d'un aéronef (100), **caractérisé en ce qu'**il comprend au moins les étapes suivantes :
- découper une piste métallique (2) conductrice dans une plaque en matériau métallique conducteur ;
- appliquer un film (6) de résine contre la piste métallique (2) conductrice pour recouvrir partiellement la piste métallique (2) conductrice, afin de laisser au moins une zone (8) dépourvue de film (6) de résine ; et
- positionner la piste métallique (2) conductrice et le film de résine contre une face du panneau (1) de structure, de sorte que le film de résine (6) recouvre au moins partiellement la face du panneau (1) de structure pour maintenir la piste métallique (2) contre le panneau (1) de structure.

5. Procédé selon la revendication 4, comprenant l'étape suivante :
- masquer au moins une zone (8) de la piste métallique (2) conductrice avec une bande de masquage (4) recouvrant chaque zone (8) prédéterminée, et dans lequel le film de résine (6) est appliqué sur la piste métallique (2) conductrice et sur chaque bande de masquage (4).

6. Procédé selon la revendication 5, comprenant l'étape suivante :
- retirer chaque bande de masquage (4) recouverte du film (6) de résine, après le positionnement du film de résine (6) et de la piste métallique (2).

7. Procédé selon l'une des revendications 4 à 6, dans lequel le film de résine est appliqué avec une nappe de transfert (10).

8. Procédé selon la revendication 7, dans lequel le film de résine (6) et la piste métallique (2) sont positionnés de la façon suivante :
- positionner la nappe de transfert (10) avec la piste métallique (2) conductrice sur la face du panneau (1) de structure ;
- chauffer le panneau (1) de structure, la piste métallique (2) conductrice et la nappe de transfert (10) pour thermocoller le film de résine (6) sur la piste métallique (2) conductrice et la face du panneau (1) de structure ;
- retirer la nappe de transfert (10) pour conserver le film de résine (6) thermocollé sur la piste métallique (2) conductrice et la face du panneau (1) de structure.

9. Procédé selon la revendication 8, dans lequel le panneau (1) de structure est en matériau composite et le chauffage du panneau (1) de structure permet de cuire le matériau composite du panneau (1) de structure.

10. Procédé d'assemblage d'un aéronef (100) comportant une phase d'assemblage de plusieurs panneaux (1) de structure selon la revendication 1, comprenant l'étape suivante :
- connecter électriquement par contact chaque zone (8) des panneaux (1) de structure, pour former un réseau de circulation d'électricité.
